**Europäisches Patentamt**

(19) **European Patent Office**

**Office européen des brevets**

(11) Numéro de publication: **0 016 498**
**B1**

(12) # FASCICULE DE BREVET EUROPEEN

(45) Date de publication du fascicule du brevet:
**01.02.84**

(51) Int. Cl.³: **H 01 B 3/08,** C 03 C 14/00,
H 01 B 3/12

(21) Numéro de dépôt: **80200230.3**

(22) Date de dépôt: **10.03.80**

(54) **Mélange de départ pour une composition diélectrique, encre sérigraphiable comportant un tel mélange, et utilisation de cette encre.**

(30) Priorité: **23.03.79 FR 7907355**

(43) Date de publication de la demande:
**01.10.80 Bulletin 80/20**

(45) Mention de la délivrance du brevet:
**01.02.84 Bulletin 84/5**

(84) Etats contractants désignés:
**DE FR GB NL**

(56) Documents cités:
**FR - A - 1 548 697**
**FR - A - 2 227 235**
**FR - A - 2 388 381**

(73) Titulaire: **Laboratoires d'Electronique et de Physique Appliquee L.E.P., 3, Avenue Descartes, F-94450 Limeil-Brévannes (FR)**

(84) Etats contractants désignés: **FR**

(73) Titulaire: **N.V. Philips' Gloeilampenfabrieken, Groenewoudseweg 1, NL-5621 BA Eindhoven (NL)**

(84) Etats contractants désignés: **DE GB NL**

(72) Inventeur: **Baudry, Hugues, Société Civile S.P.I.D. 209 rue de l'Université, F-75007 Paris (FR)**
Inventeur: **Morhaim, Claude, Société Civile S.P.I.D. 209 rue de l'Université, F-75007 Paris (FR)**
Inventeur: **Bricout, Dominique, Société Civile S.P.I.D. 209 rue de l'Université, F-75007 Paris (FR)**

(74) Mandataire: **Gendraud, Pierre et al, 209 rue de l'Université, F-75007 Paris (FR)**

Mélange de départ pour une composition diélectrique, encre sérigraphiable comportant un tel mélange, et utilisation de cette encre

L'invention concerne la formulation d'un mélange de départ pour une composition diélectrique, comprenant au moins une phase vitreuse et au moins une phase céramique, dans des proportions volumiques respectives comprises pour la phase vitreuse entre 85 et 60%, et pour la (ou les) phase(s) céramique(s) entre 15 et 40%, la phase vitreuse étant un silicate de zinc et d'alcalino-terreux. L'invention trouve son applications dans le domaine de la microélectronique, plus spécifiquement dans la réalisation de composants et circuits passifs, en technologie couches épaisses.

De tels mélanges de départ pour compositions diélectriques sont connus de l'art antérieur, notamment du brevet français 2 388 381, qui comprend à titre de phase vitreuse, un verre de type court, non spontanément dévitrifiable, et à titre de phase céramique, de l'alumine. Ces mélanges, utilisés comme encre sérigraphiable après dispersion dans un véhicule organique, présentaient des avantages substantiels par rapport à d'autres encres présentées par des entreprises concurrentes, à savoir que dans le cas de dépôt multicouches, les cuissons successives, sous atmosphère d'azote, n'entraînaient ni des phénomènes d'écoulement, ni dégradation des propriétés électriques des couches. Cependant, des perfectionnements devaient aboutir concernant, d'une part la diminution des résidus carbonés présents dans lesdites couches, d'autre part, une amélioration de la compacité des couches, pour permettre la sérigraphie de couches supérieures.

Le premier inconvénient cité a donc été résolu en ajoutant des oxydes métalliques dans des proportions volumiques comprises entre 1 et 10%, par exemple les oxydes de praséodyme ($Pr_6O_{11}$, $PrO_2$) ou de cérium ($CeO_2$), afin d'éliminer les résidus carbonés polluants, provenant par exemple de l'adsorption du véhicule organique par la poudre d'alumine. Cependant, l'entière élimination des résidus carbonés nécessitait des fractions relativement importantes desdits additifs.

La présente invention vise à pallier les inconvénients sus-précisés, afin de réaliser une encre isolante sérigraphiable, à cuire sous atmosphère d'azote donc compatible avec les précédentes encres protégées par la Demanderesse, qui permet d'obtenir après cuisson des couches compactes et non polluées.

Pour ce faire, selon la présente invention, le mélange de départ pour composition diélectrique, comprenant au moins une phase vitreuse et au moins une phase céramique est remarquable en ce qu'une phase céramique est de l'oxyde de zinc. Bien qu'il puisse s'agir en fait du mélange de plusieurs phases céramiques, par exemple un mélange d'oxydes de zinc, cobalt et praséodyme ... nous conserverons dans ce qui suit la terminologie générale »la phase céramique«.

De cette manière, la phase céramique présente une activité de surface moins importante que l'alumine en poudre fine, et ainsi elle adsorbe moins la fraction organique, alors que de plus le passage de l'oxyde de zinc, de la phase céramique à la phase vitreuse, dans le but de dévitrifier ladite phase, est moins tributaire de la granulométrie des poudres, et l'addition d'un oxydant susceptible d'éliminer les résidus carbonés peut être alors limitée à de faibles quantités, par exemple 0,5 à 5% du volume.

Selon une réalisation de l'invention, la composition diélectrique est remarquable en ce que la phase vitreuse est constituée par des proportions molaires des oxydes suivants de 30−55% de $SiO_2$, 20−40% de ZnO, 0−20% de $B_2O_3$, 0−10% de $Al_2O_3$, 5−40% de CaO + SrO + BaO, et éventuellement 0−10% de CoO choisi comme oxyde colorant.

Selon une réalisation préférentielle, les proportions molaires sont choisies égales à 50% de $SiO_2$, 20% de ZnO, 5% de $B_2O_3$, 5% de $Al_2O_3$, 15% de BaO, et 5% de CoO choisi ici comme oxyde colorant de la phase vitreuse. De cette manière, le verre est bien adapté à une cuisson sous azote. D'autre part, la réaction plus aisée avec l'oxyde de zinc autorise le choix d'un verre à température de ramollissement plus élevée, et plus visqueux que celui mis en œuvre avec l'alumine, ce qui d'une part permet à l'oxydant de mieux remplir sa fonction, et d'autre part conduit à une meilleure définition après cuisson, des motifs sérigraphiés.

Selon une variante de l'invention, la phase vitreuse peut se composer d'un mélange de verres, dont l'un est spontanément dévitrifiable.

On a constaté expérimentalement que, de cette manière, la couche obtenue après cuisson est plus compacte, et les sérigraphies ultérieures des couches supérieures sont améliorées dans une large mesure. On se donne ainsi un nouveau moyen, hormis la température de cuisson, pour améliorer la compacité de la couche diélectrique.

Selon une seconde variante de l'invention, le mélange de départ pour une composition diélectrique est remarquable en ce qu'il comprend plusieurs phases céramiques, une première phase céramique étant de l'oxyde de zinc et une seconde phase céramique étant de l'oxyde de cobalt.

La description qui va suivre, en regard des dessins annexés, donnés seulement à titre figuratif, permettra de mieux comprende comment l'invention peut être réalisée.

La figure 1a représente schématiquement une structure multicouches sérigraphiée, sur un substrat par exemple d'alumine en vue de dessus, et la figure 1b une coupe selon l'axe I-I.

La figure 2 représente un cycle de cuisson dans le temps, d'une couche sérigraphiée.

La figure 3 représente un exemple d'un diagramme d'analyse thermique différentielle.

Il est connu de l'art antérieur, des formulations de matériaux de départ pour une composition

2

diélectrique, pour la préparation ultérieure d'encre et qui comprennent généralement une phase vitreuse et une phase céramique, dans des proportions volumiques relativement larges, comprises pour la phase vitreuse entre 70% et 40% pour la phase céramique entre 30% et 60%.

Dans le brevet précédemment cité, de numéro 2 388 381, il est décrit notamment une composition diélectrique compatible avec le système d'encre développé par la Demanderesse, à partir d'une encre au cuivre, imposant une cuisson sous atmosphère non oxydante, et dont la phase vitreuse est un verre de type court, plus particulièrement un borosilicate de zinc, et la phase céramique de l'alumine.

L'originalité de la présente invention réside dans le fait d'utiliser à titre de phase céramique de l'oxyde de zinc ou un mélange d'oxydes de zinc et de cobalt, alors que la composition du verre est quelque peu différente, notamment en ce que la température de ramollissement et la viscosité sont sensiblement augmentées.

Les verres utilisés sont précisés dans le tableau suivant, où l'on indique en outre une composition additionnelle spontanément dévitrifiable.

| Composants | Composition vitrifiable de base | | Composition additionnelle |
|---|---|---|---|
| | Pourcentage molaire | Composition préférentielle | Composition spontanément dévitrifiable |
| $SiO_2$ | 30–55% | 50% | 48% |
| ZnO | 20–40% | 20% | 29% |
| $B_2O_3$ | 0–20% | 5% | — |
| $Al_2O_3$ | 0–10% | 5% | — |
| BaO + CaO + SrO | 5–40% | 15% BaO | 23% CaO |
| CoO | 0–10% | 5% | — |
| $\rho$ (kg/m$^3$) | | 3532 | 3403 |
| $10^7 \cdot \alpha$ (°C$^{-1}$) | | 64,8 | 64,6 |
| PRS (°C) | | 617°C | 640°C |
| PRD (°C) | | 650°C | 663°C |

Il est indiqué également dans ce tableau, outre la composition, la masse volumique en kg/m$^3$, le coefficient de dilatation pris entre 20 et 320°C, le point de recuit supérieur (PRS) en °C, et le point de ramollissement dilatométrique (PRD) en °C.

Selon les enseignements de la présente invention, on réalise un verre dans des proportions molaires correspondant aux fourchettes, indiquées, une composition préférentielle étant celle décrite dans la deuxième colonne. Ce verre ou l'un des verres de la fourchette peut être mis en œuvre en mélange avec une composition vitreuse de la même famille (silicate de zinc et d'alcalino-terreux) mais qui, de par sa composition se trouve être, dans les conditions de l'expérience (fritte de verre soumise à refusion), spontanément dévitrifiable (3ème colonne). La composition diélectrique, selon l'invention, s'obtient en mélangeant intimement la ou les frittes des verres ainsi obtenues avec une poudre céramique d'oxyde de zinc, ou un mélange de poudres d'oxydes de zinc et de cobalt dans des proportions volumiques respectives pour la phase vitreuse entre 85 et 60% et pour la phase céramique entre 15 et 40%. Préférentiellement, on peut choisir pour la phase vitreuse une proportion volumique de 78% et pour la phase céramique de 22% (répartis comme suit: 11% de ZnO, 7% de CoO, 4% de $PrO_2$), proportions qui ont permis d'obtenir les meilleurs résultats tant du point de vue du comportement mécanique, que du point de vue du comportement électrique des couches obtenues par la suite et des possibilités de cuissons multiples requises dans la technologie de circuiterie multicouches connue des hommes de l'art.

Les encres sérigraphiables, selon l'invention, s'obtiennent en dispersant les compositions diélectriques dans un véhicule organique approprié à la sérigraphie. En tant que tel, il est utilisé fréquemment une solution d'éthyl cellulose, dans du terpinéol ou un mélange à base de terpinéol. Dans l'encre sérigraphiable, avant cuisson, le véhicule organique peut représenter de 10 à 40% en poids, le véhicule et sa proportion étant choisis en fonction du comportement rhéologique souhaité.

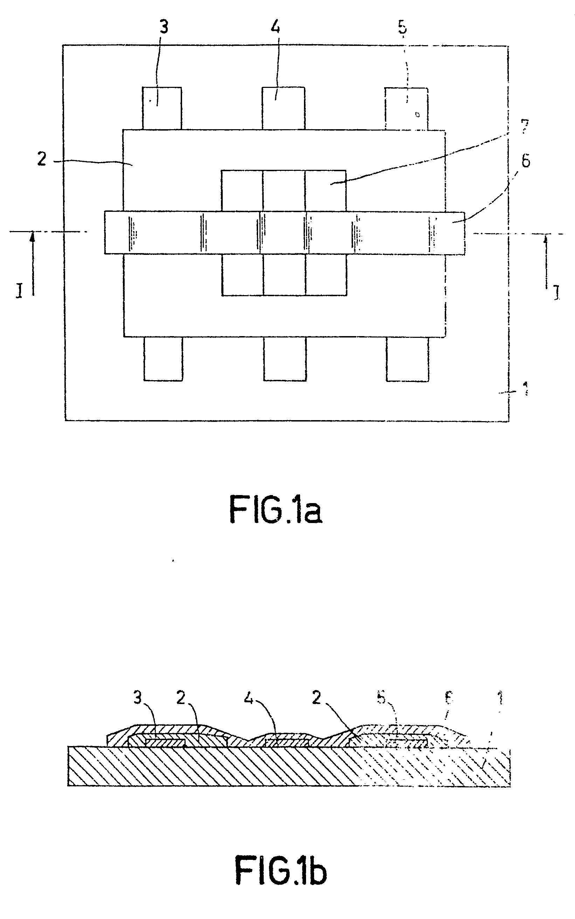

L'encre est alors imprimée à travers un écran de sérigraphie de manière à obtenir un dépôt tel que celui représenté par exemple à la figure 1, donnée en annexe, et qui représente sur un substrat par exemple d'alumine 1, un motif d'impression multicouches 2, en une vue de dessus (figure 1a) et en une vue en coupe (figure 1b), selon l'axe I-I. Ce motif 2 réalisé avec la composition diélectrique selon l'invention est placé entre trois conducteurs inférieurs 3, 4 et 5 de préférence en cuivre et un conducteur supérieur 6 du même matériau et isole de ce conducteur 6 les conducteurs 3 et 5, tandis qu'il permet, grâce à l'évidement 7, d'établir une liaison entre les conducteurs 4 et 6. Selon les règles habituelles de l'art, la couche 2 peut être le résultat d'une double impression, pour garantir au mieux l'absence de court-circuits.

La composition diélectrique selon l'invention permet la réalisation de structures comportant un grand nombre de tels niveaux de conducteurs et d'isolants, des empilements de 5 niveaux conducteurs séparés par 4 double-niveaux d'isolants ont été par exemple couramment réalisés par la Demanderesse.

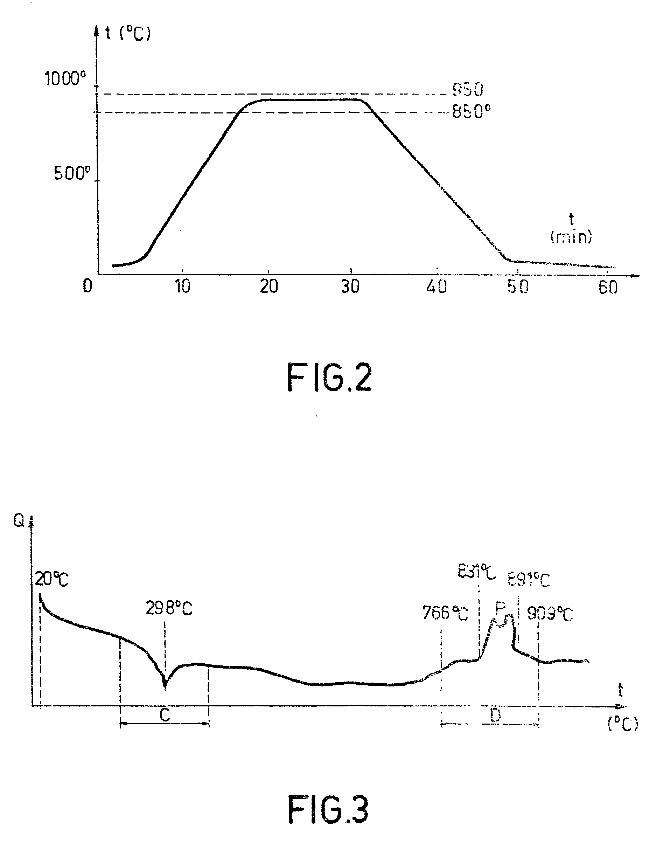

La cuisson de la couche constituée par ce motif s'effectue sous atmosphère d'azote, à une température de palier comprise entre 850° et 950°C selon un cycle tel que décrit à la figure 2, et que présente en abscisses la durée de cette cuisson (1 heure environ) avec un palier qui dure approximativement 10 minutes, et en ordonnées les températures. La teneur en oxygène dans le four peut être maintenue inférieure à 10 ppm (parties par million), ce qui garantit une bonne protection des conducteurs en cuivre sérigraphié.

La température du palier de cuisson doit être choisie de telle façon que l'on atteigne au moins la zone de dévitrification, cette zone pouvant être déduite du diagramme d'analyse thermique différentielle du mélange considéré dont la figure 3 schématise l'allure générale (sur cette figure apparaît la zone de dévitrification D, ainsi que la zone C de décomposition de l'oxydant C). D'une manière simplifiée, les abscisses, sur ce diagramme, représentent les températures et les ordonnées des quantités de chaleur Q (échelle arbitraire). La dévitrification étant le passage d'une structure désordonnée à une structure ordonnée, elle s'accompagne d'un dégagement de chaleur (réaction exothermique), et la courbe présente un large pic positif référencé P sur la figure 3. Lorsque la phase vitreuse comporte un mélange de frittes dont l'une est spontanément dévitrifiable, ce pic se décompose alors en deux pics secondaires distincts, correspondant d'une part à la réaction verre (composition préférentielle)-céramique et d'autre part à la cristallisation de la composition spontanément dévitrifiable; la largeur du pic P correspond à la zone de dévitrification.

Des mesures électriques précises ont été effectuées par la Demanderesse sur la courbe isolante obtenue conformément aux enseignements ci-dessus, pour en déterminer ses propriétés diélectriques, mesures résumées dans le tableau ci-dessous:

| | Messures |
|---|---|
| $\varepsilon =$ | 7 |
| $10^3 \times tg\, \delta =$ | 2—5 de 10 KHz à 1 MHz |

Cette couche présentait une résistance supérieure à $10^{10}\ \Omega$, mesurée pour une surface de 1 cm² et une épaisseur de 40 μm, sous une tension de 50 Volts. Aucune porosité ne pouvait être décelée par les moyens classiques (diffusion de liquide, ressuage . . .).

Des analyses cristallographiques précises des couches ont permis de déterminer les principales phases cristallines formées au cours de la cuisson: par dissolution des oxydes de zinc et de cobalt dans la phase initialement vitreuse, cette phase se dévritrifie en donnant une (ou plusieurs phase(s) cristalline(s) qui vient (viennent) consolider la structure de la couche diélectrique. Il semble ainsi, qu'il s'est formé de la willemite ($Zn_2SiO_4$: orthosilicate de zinc) de la hardystonite ($ZnCa_2Si_2O_7$: silicate de zinc-calcium) où le baryum peut être également substitué au calcium.

Avec une composition de verre plus riche en Alumine ($Al_2O_3$) on peut orienter la dévitrification vers la production de gahnite $ZnAl_2O_4$. De plus, la Demanderesse a constaté expérimentalement que les silicates de zinc et surtout de zinc et d'alcalino-terreux participaient à l'élimination des résidus organiques du véhicule. Il semble que ces phases céramiques possèdent un certain pouvoir oxydant: c'est le rapport entre les concentrations respectives en oxydes de zinc et de cobalt qui permet de fixer la teneur en phases cristallines à base de silicates de zinc et de zinc-alcalino-terreux.

D'autres compositions diélectriques ont été également étudiées sans donner de meilleurs résultats. Toutefois, il est bien entendu que de nombreuses variantes sont possibles à l'intérieur des fourchettes de composition données, ou dans la forme de réalisation des circuits mettant en œuvre une composition diélectrique selon l'invention, ou dans des substituants équivalents, sans pour cela qu'il soit fait œuvre d'esprit, donc sans pour cela sortir du cadre de la présente invention telle que revendiquée ci-après.

**Revendications**

1. Mélange de départ pour une composition diélectrique, comprenant une phase vitreuse et au moins une phase céramique, dans des proportions volumiques respectives pour la phase vitreuse entre 85 et 60%, et pour la (ou les) phase(s) céramique(s) entre 15 et 40%, la phase vitreuse étant un silicate de zinc et d'alcalinoterreux, caractérisé en ce que la (ou une) phase céramique est de l'oxyde de zinc.

2. Mélange de départ pour une composition diélectrique selon la revendication 1, caractérisé en ce que la phase vitreuse est constituée par des proportions molaires des oxydes suivants de $30-55\%$ de $SiO_2$, $20-40\%$ de $ZnO$, $0-20\%$ de $B_2O_3$, $0-10\%$ de $Al_2O_3$, $5-40\%$ de $CaO + SrO + BaO$ et $0-10\%$ de $CoO$ choisi comme oxyde colorant.

3. Mélange de départ pour une composition diélectrique selon la revendication 2, caractérisé en ce que la phase vitreuse est constituée par les proportions molaires respectives suivantes de 50% de $SiO_2$, 20% de $ZnO$, 5% de $B_2O_3$, 5% de $Al_2O_3$, 15% de $BaO$, et 5% de $CoO$ choisi comme oxyde colorant.

4. Mélange de départ pour une composition diélectrique selon la revendication 1, caractérisé en ce que la phase vitreuse peut se composer d'un mélange de verres, dont l'un est spontanément dévitrifiable.

5. Mélange de départ pour une composition diélectrique selon la revendication 4, caractérisé en ce que le verre spontanément dévitrifiable est constitué par des proportions molaires des oxydes suivants de 48% de $SiO_2$, 29% de $ZnO$ et 23% de $CaO$.

6. Mélange de départ pour une composition diélectrique selon la revendication 1, caractérisé en ce qu'une autre phase céramique est de l'oxyde de cobalt.

7. Mélange de départ pour une composition diélectrique selon l'une des revendications 1 à 6, caractérisé en ce qu'il contient en outre une autre phase céramique constituée par des oxydes choisis parmi le groupe $Pr_6O_{11}$, $PrO_2$, $CeO_2$, en des proportions volumiques comprises entre 0,5 et 5%.

8. Mélange de départ pour une composition diélectrique selon la revendication 7, caractérisé en ce qu'il comprend en volume, 11% de $ZnO$, 7% de $CoO$, 4% de $PrO_2$ en phases céramiques et 78% en phase vitreuse.

9. Encre sérigraphiable comportant, dispersé dans un véhicule organique tel qu'une solution d'éthyl cellulose dans du terpinéol, un mélange de départ selon l'une des revendications 1 à 8.

10. Utilisation d'une encre sérigraphiable selon la revendication 9, en vue de fabriquer des composants électriques, comprenant au moins une couche, ou un empilement de couches, déposée(s) sur un substrat par exemple d'alumine, à travers un écran de sérigraphie, et cuite(s) sous atmosphère d'azote, sous une faible pression partielle d'oxygène, inférieure à 10 ppm, à une température de palier comprise entre 850° et 950°C, pendant au moins dix minutes.

**Patentansprüche**

1. Ausgangsgemisch für eine dielektrische Zusammensetzung, die eine glasartige Phase und mindestens eine keramische Phase umfaßt in jeweiligen Volumenverhältnissen, die für die glasartige Phase zwischen 85 und 60% und für die keramische Phase(n) zwischen 15 und 40% liegen, wobei die glasartige Phase ein Zink- und Erdalkalisilikat ist, dadurch gekennzeichnet, daß die (oder eine) keramische Phase Zinkoxyd ist.

2. Ausgangsgemisch für eine dielektrische Zusammensetzung nach Anspruch 1, dadurch gekennzeichnet, daß die glasartige Phase aus Molverhältnissen der nachfolgenden Oxyde von 30 bis 55% $SiO_2$, 20 bis 40% $ZnO$, 0 bis 20% $B_2O_3$, 0 bis 10% $Al_2O_3$, 5 bis 40% $CaO + SrO + BaO$ und 0 bis 10% $CoO$, das als Farboxyd gewählt ist, besteht.

3. Ausgangsgemisch für eine dielektrische Zusammensetzung nach Anspruch 2, dadurch gekennzeichnet, daß die glasartige Phase aus den folgenden jeweiligen Molverhältnissen von 50% $SiO_2$, 20% $ZnO$, 5% $B_2O_3$, 5% $Al_2O_3$, 15% $BaO$ und 5% $CoO$ besteht, das als Farboxyd gewählt ist, besteht.

4. Ausgangsgemisch für eine dielektrische Zusammensetzung nach Anspruch 1, dadurch gekennzeichnet, daß die glasartige Phase aus einem Gemisch von Glasarten, von denen eine spontan entglasbar ist, zusammengesetzt ist.

5. Ausgangsgemisch für eine dielektrische Zusammensetzung nach Anspruch 4, dadurch gekennzeichnet, daß das spontan entglasbare Glas aus Molverhältnissen der folgenden Oxyde von 48% $SiO_2$, 29% $ZnO$ und 23% $CaO$ besteht.

6. Ausgangsgemisch für eine dielektrische Zusammensetzung nach Anspruch 1, dadurch gekennzeichnet, daß eine andere keramische Phase Kobaltoxyd ist.

7. Ausgangsgemisch für eine dielektrische Zusammensetzung nach einem der Ansprüche 1 bis 6, dadurch gekennzeichnet, daß diese außerdem eine andere keramische Phase aufweist, die aus Oxyden besteht, die in der Gruppe $Pr_6O_{11}$, $PrO_2$, $CeO_2$ gewählt sind, und zwar in Volumenteilen, die zwischen 0,5 und 5% liegen.

8. Ausgangsgemisch für eine dielektrische Zusammensetzung nach Anspruch 7, dadurch

**0 016 498**

gekennzeichnet, daß dieses Gemisch 11 Vol.-% ZnO, 7 Vol.-% CoO, 4 Vol.-% PrO$_2$ als keramische Phase und 78 Vol.-% als glasartige Phase enthält.

9. Siebdrucktinte, die in Dispersion in einem organischen Träger wie einer Lösung von Äthylzellulose in Terpineol, ein Ausgangsgemisch nach einem der Ansprüche 1 bis 8 enthält.

10. Verwendung einer Siebdrucktinte nach Anspruch 9 zum Herstellen elektrischer Schaltungselemente, die mindestens eine Schicht umfaßt oder einen Stapel von Schichten, die auf einem Substrat aus beispielsweise Aluminiumoxyd aufgetragen ist (sind), und zwar durch einen Siebdruckschirm hindurch und in einer Stickstoffatmosphäre unter einem geringen partiellen Sauerstoffdruck, welcher Druck niedriger ist als 10 ppm während mindestens 10 Minuten auf einem Temperaturpegel zwischen 850 und 950° C, gebrannt ist (sind).

## Claims

1. Starting mixture for a dielectric composition comprising a vitreous phase and at least one ceramic phase in quantities by volume for the vitreous phase between 85 and 60% and for the ceramic phase or phases between 15 and 40%, respectively, the vitreous phase being a zinc silicate and an alkaline earth silicate, characterized in that at least the (or one) ceramic phase is zinc oxide.

2. Starting mixture for a dielectric composition as claimed in Claim 1, characterized in that the vitreous phase is constitued by the following oxides in a molar quantity of 30 – 55% SiO$_2$, 20 – 40% ZnO, 0 – 20% B$_2$O$_3$, 0 – 10% Al$_2$O$_3$, 5 – 40% CaO + SrO + BaO and 0 – 10% of CoO as colouring oxide.

3. Starting mixture for a dielectric composition as claimed in Claim 2, characterized in that the vitreous phase is constituted by the following molar quantities of 50% SiO$_2$, 20% ZnO, 5% B$_2$O$_3$, 5% Al$_2$O$_3$, 15% BaO and 5% CoO, chosen as a colouring oxide.

4. Starting mixture for a dielectric composition as claimed in Claim 1, characterized in that the vitreous phase is composed of a mixture of glasses, one glass of which is spontaneously devitrifiable.

5. Starting mixture for a dielectric composition as claimed in Claim 4, characterized in that the spontaneously devitrifiable glass contains the following oxides in molar quantities of 48% SiO$_2$, 29% ZnO and 23% CaO.

6. Starting mixture for a dielectric composition as claimed in Claim 1, characterized in that a further ceramic phase is cobalt oxide.

7. Starting mixture for a dielectric composition as claimed in any of Claims 1 to 6, characterized in that it comprises inter alia a further ceramic phase constituted by oxides chosen from the group Pr$_6$O$_{11}$, PrO$_2$, CeO$_2$, in quantities by volume between 0.5 and 5%.

8. Starting mixture for a dielectric composition as claimed in Claim 7, characterized in that it comprises in quantities by volume, 11% ZnO, 7% CoO, 4% PrO$_2$ for the ceramic phase and 78% for the vitreous phase.

9. A screen-printing paste comprising a starting mixture as claimed in any of Claims 1 to 8, dispersed in an organic vehicle such as a solution of ethyl cellulose in terpineol.

10. The use of a screen-printing paste as claimed in Claim 9, for manufacturing electrical components, comprising at least a layer or a pile of layers, deposited on a substrate of, for example, aluminium oxide, through a silk screen, and fired in a nitrogen atmosphere with a low partial pressure of oxygen of less than 10 ppm, at a plateau temperature between 850° and 950° C, for at least 10 minutes.

# FIG.1a

# FIG.1b

FIG.2

FIG.3